# DEMANDE DE BREVET EUROPEEN

(11) **EP 0 807 974 A1**
(43) Date de publication de la demande: **19.11.1997**
(21) Numéro de dépôt: 97410041.4
(22) Date de dépôt: 09.04.1997
(51) Int. Cl.: H01L 23/532

(54) **Interconnexions multicouches à faible capacité parasite latérale**

(30) Priorité: 10.04.1996 FR 9604746
(71) Demandeur: SGS-THOMSON MICROELECTRONICS S.A., 94250 Gentilly (FR)
(72) Inventeur: Marty, Michel, 38760 Varces (FR); Passemard, Gérard, 38660 La Terrasse (FR); Wyborn, Graeme, 38330 Montbonnot (FR)
(74) Mandataire: de Beaumont, Michel

(57) **Abrégé**

L'invention concerne une structure d'interconnexion dans laquelle la surface supérieure d'un premier niveau d'interconnexion (1) est une couche de tungstène (13, 14), des portions (11, 12) du premier niveau d'interconnexion sont isolées les unes des autres par un isolant de type SOG (41), des portions (21, 22) d'un deuxième niveau d'interconnexion (2) sont reliées à des portions (11, 12) du premier niveau d'interconnexion par des plots conducteurs (33, 34) formés dans des ouvertures de la couche isolante de type SOG, les parois et le fond desdites ouvertures sont recouverts d'une couche mince de titane (31), et les ouvertures sont remplies d'un matériau conducteur choisi dans le groupe comprenant Al, Cu et des alliages d'aluminium.

## Description

La présente invention concerne le domaine des composants semiconducteurs et notamment des circuits intégrés. Elle concerne plus particulièrement la structure et la fabrication des réseaux de connexion multicouches formés sur de tels composants.

Dans un circuit intégré formé sur une puce de silicium dans laquelle sont formées diverses régions de types de dopage différents, correspondant par exemple à des drains, sources et grilles de transistors MOS, on doit réaliser des contacts sur ces régions, relier certaines de ces régions entre elles, et accéder à des bornes de sortie. Pour résoudre les problèmes d'interconnexion et de croisement de connexions, on est amené à réaliser plusieurs niveaux d'interconnexion, couramment appelés métallisations bien que les éléments conducteurs de connexion ne soient pas toujours des métaux mais puissent être divers matériaux conducteurs appropriés. Dans la description suivante, l'expression "niveau de métallisation" désigne une couche conductrice formée à une étape donnée et gravée de façon appropriée, et l'expression "via" désigne un passage formé dans une couche isolante entre deux niveaux de métallisation et rempli d'un matériau conducteur pour permettre des liaisons localisées entre des portions de deux niveaux de métallisation distincts.

On connaît diverses structures et procédés pour la réalisation de ces métallisations et vias. Toutefois, il existe un besoin constant d'amélioration de ces structures et procédés notamment en raison de la miniaturisation croissante des circuits intégrés. Actuellement, on arrive à des dimensions élémentaires inférieures à 1 µm. Il est clair que pour de telles dimensions, des structures et procédés développés pour des structures dans lesquelles les dimensions minimales étaient supérieures au micromètre ne conviennent plus et que de nouveaux procédés doivent être développés. Les modifications peuvent parfois apparaître très minimes mais elles sont fondamentales en ce qu'elles rendent possible ce qui était impossible.

Outre les divers problèmes de bon remplissage des vias et de compatibilité entre les matériaux, les réductions de dimension des circuits intégrés rendent deux problèmes particuliers liés aux connexions plus particulièrement aigus. Le premier problème réside dans le fait que, pour des circuits de grande dimension, les capacités parasites entre niveaux de métallisation sont prédominantes par rapport aux capacités latérales entre portions d'un même niveau de métallisation tandis que cette relation tend à s'inverser quand la miniaturisation s'accroît. Le deuxième problème réside dans le fait que, tandis que la miniaturisation s'accroît, le nombre de composants formés dans une même puce de silicium augmente et donc que le nombre de connexions augmente corrélativement. Il en résulte que la résistance des interconnexions, des vias et des interfaces interconnexions/vias devient un problème critique, plus particulièrement quand on veut que le circuit intégré puisse fonctionner à des fréquences élevées.

Ainsi, un objet de la présente invention est de prévoir une nouvelle structure et un nouveau procédé de fabrication de réseaux d'interconnexion permettant de pallier les deux problèmes susmentionnés.

Un autre objet de la présente invention est de prévoir un procédé de fabrication de niveaux d'interconnexion utilisant essentiellement des techniques individuelles connues en elles-mêmes dans le domaine de la fabrication des circuits intégrés.

Pour atteindre ces objets, la présente invention prévoit une structure d'interconnexion dans laquelle la surface supérieure d'un premier niveau d'interconnexion est une couche de tungstène, des portions du premier niveau d'interconnexion sont isolées les unes des autres par un isolant de type SOG, des portions d'un deuxième niveau d'interconnexion sont reliées à des portions du premier niveau d'interconnexion par des plots conducteurs formés dans des ouvertures d'une couche isolante dont au moins la partie inférieure est de type SOG, les parois et le fond desdites ouvertures sont recouverts d'une couche mince de titane, et les ouvertures sont remplies d'un matériau conducteur choisi dans le groupe comprenant Al, Cu et des alliages d'aluminium tels que des alliages de silicium, de cuivre, de titane...

Selon un mode de réalisation de la présente invention, une couche mince de TiN est formée sous la couche mince de titane.

Selon un mode de réalisation de la présente invention, l'épaisseur de la couche de titane est inférieure à 30 nm et de préférence inférieure à 10 nm.

Selon un mode de réalisation de la présente invention, l'épaisseur de la couche de TiN est de l'ordre d'une dizaine de nanomètres.

La présente invention prévoit aussi un procédé de formation de deux niveaux d'une structure d'interconnexion, comprenant les étapes consistant à former un premier niveau d'interconnexion en un matériau choisi dans le groupe comprenant Al, Cu et des alliages d'aluminium tels que des alliages de silicium, de cuivre, de titane..., graver ce premier niveau d'interconnexion selon un motif choisi, recouvrir la structure d'une couche isolante dont la partie inférieure, s'étendant entre les portions du premier niveau d'interconnexion et sur la surface supérieure du premier niveau d'interconnexion, est en un matériau de type SOG, graver des ouvertures dans la couche isolante en regard de portions choisies du premier niveau d'interconnexion, déposer une couche mince de titane, former un deuxième niveau d'interconnexion et remplir lesdites ouvertures par dépôt à une température supérieure à 500°C d'un matériau choisi dans le groupe comprenant Al, Cu et des alliages d'aluminium.

Selon un mode de réalisation de la présente invention, ce procédé comprend en outre l'étape consistant à déposer sur le deuxième niveau d'interconnexion une couche mince de titane et une couche mince de tungstène et à graver ce deuxième niveau d'interconnexion selon des motifs choisis.

Selon un mode de réalisation de la présente invention, une couche mince de TiN est déposée avant la couche mince de titane.

Selon un mode de réalisation de la présente invention, l'épaisseur de la couche de titane est inférieure à 30 nm et de préférence inférieure à 10 nm.

Selon un mode de réalisation de la présente invention, l'épaisseur de la couche de TiN est de l'ordre d'une dizaine de nanomètres.

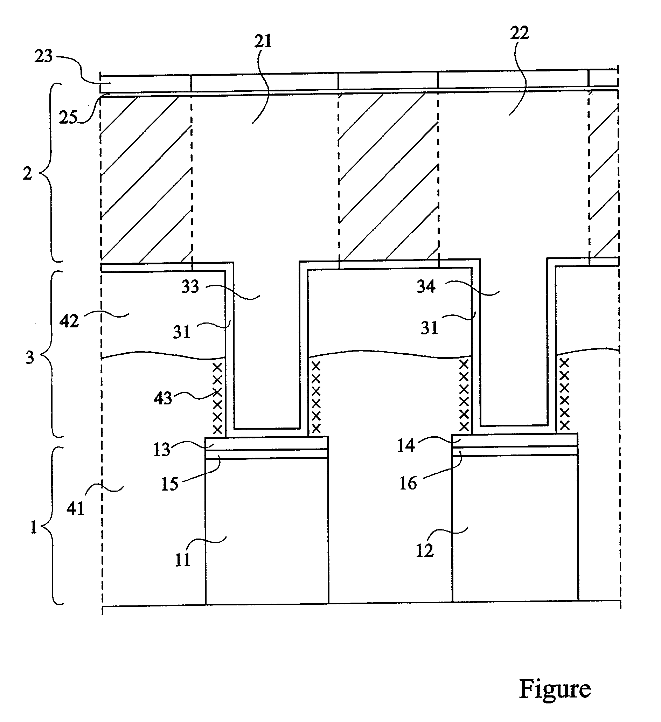

Ces objets, caractéristiques et avantages, ainsi que d'autres de la présente invention seront exposés plus en détail dans la description suivante d'un mode de réalisation particulier faite, à titre non-limitatif, en relation avec la figure jointe qui représente une vue en coupe d'une portion de deux niveaux d'une structure d'interconnexion selon la présente invention.

De façon générale, la figure unique est divisée verticalement en trois zones, une zone 1 dans laquelle apparaissent des portions d'un premier niveau de métallisation, une zone 2 où apparaissent des portions d'un deuxième niveau de métallisation et une zone 3 comprenant des vias reliant des portions choisies des premier et deuxième niveaux de métallisation.

Il sera clair que, bien que l'on parle par souci de simplification dans la présente description d'un premier et d'un deuxième niveau de métallisation, ceci ne signifie pas que le premier niveau de métallisation est le niveau le plus bas d'une structure d'interconnexion. Ce premier niveau peut être un niveau intermédiaire quelconque lui-même formé au-dessus d'un niveau de métallisation inférieur. En ce cas, l'assemblage entre ce niveau intermédiaire et le niveau inférieur sera du même type que celui décrit ici en relation avec les premier et deuxième niveaux de métallisation.

Plus particulièrement, dans la figure, on a représenté pour le premier niveau de métallisation 1 deux portions de métallisation 11 et 12 qui peuvent être des plots, des lignes de connexion ou des portions de ligne de connexion. Ces régions 11 et 12 résultent d'un dépôt uniforme d'une couche de métallisation suivi d'une gravure. Le premier niveau de métallisation est revêtu d'une couche d'un matériau isolant qui remplit les espaces entre les portions 11 et 12 et recouvre l'ensemble de la structure.

Avec les technologies actuelles, la hauteur des portions conductrices 11 et 12 peut être de l'ordre de 1 µm tandis que la distance entre ces portions 11 et 12 peut être seulement de 0,5 µm. On voit donc que la capacité latérale entre ces portions n'est plus négligeable.

Pour réduire ces capacités latérales parasites, selon un premier aspect de la présente invention, il est prévu d'utiliser comme produit d'isolement entre et au-dessus des portions 11 et 12 un produit tel que couramment désigné dans la technique par l'acronyme SOG d'après l'expression anglo-saxonne Spin On Glass (verre déposé à la tournette). On propose plus particulièrement d'utiliser un SOG organique constitué d'un polysiloxane additionné d'un diluant (de l'alcool) qui, après recuit, forme un isolant dont la constante diélectrique est inférieure à 3 et typiquement d'une valeur de 2,6 à 2,8. Pour comparaison, on notera que les isolants classiquement utilisés dans les technologies modernes sont de l'oxyde TEOS formé à partir de tétraéthylorthosilane dont la constante diélectrique est de 4,4 ou un oxyde déposé par résonance cyclotronique électronique dont la constante diélectrique est de l'ordre de 4. Plus particulièrement, la couche de SOG est formée par dépôt à la tournette du produit susmentionné (polysiloxane plus alcool) puis un recuit à une température de 400 à 500°C pour évacuer le diluant et polymériser le matériau qui se transforme essentiellement en oxyde de silicium (SiOₓ) additionné de radicaux carbonés ou hydrogénés. Ce procédé présente l'avantage qu'il n'implique pas d'étape réalisée dans un plasma pour le dépôt d'où il résulte qu'il n'y a pas de création de charges à l'intérieur de la couche isolante formée. Ce dépôt est en outre peu coûteux et ne nécessite pas d'appareillage complexe.

On notera que cette utilisation de SOG comme isolant d'un niveau d'interconnexion n'est pas usuelle, le SOG étant généralement utilisé dans la technique essentiellement pour ses capacités de planarisation. En effet, après dépôt et recuit, la couche de SOG présente une surface sensiblement plane.

Dans la figure, on a désigné la couche d'isolant du premier niveau d'interconnexion par les références 41 et 42. La référence 41 désigne la couche de SOG. Bien que l'on ait indiqué précédemment que le SOG présente des qualités naturelles de planarisation, sa surface supérieure n'est en fait pas parfaitement plane à l'échelle submicronique. On préférera donc pour des structures de très petites dimensions redéposer au-dessus de la couche de SOG 41 une couche de TEOS 42 puis procéder à une étape de planarisation mécano-chimique (CMP).

Après la formation de l'isolement 41-42, la couche isolante est de façon classique gravée aux emplacements où l'on souhaite former des vias. Pour cela, de façon classique, la couche isolante est revêtue d'une résine photosensible qui est ouverte aux emplacements appropriés pour fournir un masque de gravure de l'isolant. On grave alors les vias 3 jusqu'à atteindre la surface supérieure des portions 11 et 12 visées du premier niveau d'interconnexion. Après cela, on enlève la résine pour préparer les étapes suivantes. Un inconvénient connu du SOG est que ce matériau est microporeux et que, lors de l'enlèvement de la résine effectué en présence d'oxygène, l'oxygène pénètre dans les canaux et forme avec les constituants du SOG des molécules d'eau et autres composés oxydants qui sont ensuite susceptibles de désorber lors de traitements thermiques sous vide ou sous plasma et d'oxyder des surfaces apparentes ou en cours de traitement. Cette zone polluée est symbolisée dans la figure par des croix 43. C'est sans doute la raison pour laquelle on a évité dans l'art antérieur d'utiliser du SOG comme matériau d'isolement et particulièrement dans les zones où sont formés les vias.

Selon un deuxième aspect de la présente invention, il est prévu d'utiliser comme matériaux principaux constitutifs des couches d'interconnexion et des vias, des matériaux fortement conducteurs tels que de l'aluminium, du cuivre, ou des alliages d'aluminium avec Cu, Si, Ti... (par exemple AlSi, AlSiCu, AlSiTi) par un procédé évitant tout inconvénient lié à des éventuelles désorptions de composés oxydants à partir des parties gravées d'une couche de SOG.

Ainsi, selon la présente invention, les portions 11 et 12 sont en Al, Cu ou alliage d'aluminium. La surface supérieure de chacune des portions 11 et 12 est revêtue d'une couche de tungstène, respectivement 13 et 14. Dans le cas où le premier niveau de métallisation est en Al ou en alliage d'aluminium, il est nécessaire de prévoir une couche mince de TiN, respectivement 15 et 16, entre les régions 11-13 et 12-14 pour éviter la formation d'une pellicule isolante résultant de réactions entre le fluor et l'aluminium, le fluor existant du fait que les dépôts de tungstène sont réalisés à partir de fluorures de tungstène.

Ensuite, après la formation décrite précédemment des ouvertures dans la couche isolante 41-42, on procède au dépôt uniforme d'une couche mince de titane 31 qui revêt la surface de la structure ainsi que les parois latérales et de fond des ouvertures.

On notera que, pendant le dépôt de titane, la présence des couches supérieures de tungstène 13 et 14 évite tout inconvénient lié à une désorption des sites oxydants 43 car les oxydes de tungstène sont volatiles et sont évacués sans création d'une couche isolante.

Ensuite, on procède à des dépôts simultanés d'une couche d'aluminium, de cuivre ou d'alliage d'aluminium qui forme le deuxième niveau d'interconnexion 2 et le remplissage 33, 34 des vias. Ce remplissage est réalisé par une technique de dépôt à chaud. Dans le cas de l'aluminium, le dépôt est réalisé à une température de plaque supérieure à 400°C de sorte que le métal flue dans le via pendant le dépôt. La mouillabilité du métal le long des parois du via est favorisée par la sous-couche de titane 31.

Avant le dépôt de la couche mince de titane 31, on peut déposer une couche mince de nitrure de titane (TiN) (non représentée). Dans le cas où le deuxième niveau d'interconnexion 2 est un niveau intermédiaire et que l'on prévoit de former un autre niveau selon la présente invention au-dessus de ce deuxième niveau, la couche métallique est revêtue d'une couche de tungstène 23 avec interposition d'une couche de TiN 25. Ensuite, on grave le deuxième niveau d'interconnexion pour laisser en place des plots ou pistes 21, 22 en éliminant les parties illustrées dans la figure par hachures.

En ce qui concerne la réduction de la résistivité, la présente invention présente un avantage notable par rapport aux structures utilisant du tungstène pour les vias ou les couches d'interconnexion. En effet, la résistivité de l'aluminium est de l'ordre de 3 µΩ/cm alors que celle du tungstène est de l'ordre de 11 µΩ/cm.

En outre, si le deuxième niveau d'interconnexion est de l'aluminium et que le remplissage du plot est également de l'aluminium (ou un alliage d'aluminium ou Cu), la couche barrière et de mouillabilité 31 (Ti) peut être beaucoup plus mince que celle de l'art antérieur. En effet, quand on veut graver le deuxième niveau d'interconnexion, si celui-ci ou le remplissage du via est en tungstène, il faut utiliser pour la gravure un plasma fluoré. Un plasma fluoré présente une faible sélectivité entre la gravure du tungstène et la gravure de l'oxyde. Il est alors obligatoire que la couche barrière de TiN ou Ti/TiN soit relativement épaisse (supérieure à 100 nm) sur la surface supérieure de la couche isolante 41-42 pour permettre un arrêt de gravure du deuxième niveau d'interconnexion. Par contre, une couche en aluminium ou en alliage d'aluminium se grave par un plasma chloré qui est très sélectif par rapport à l'oxyde. Il n'est alors plus nécessaire de prévoir une couche d'arrêt de gravure et l'épaisseur de la couche barrière 31 est réduite à son minimum pour satisfaire seulement à sa fonction de barrière et de mouillabilité et non plus d'arrêt de gravure. La réduction de l'épaisseur de ces couches est particulièrement importante en pratique puisque le titane présente une résistivité de l'ordre de 13 µΩ/cm et le TiN de l'ordre de 70 µΩ/cm. Selon l'invention, on pourra utiliser une couche de titane d'une épaisseur de 10 à 30 nm sur les flancs des vias et éventuellement une couche sous-jacente de TiN d'une épaisseur de l'ordre de 10 nm.

Ainsi, la présente invention, en utilisant des techniques simples et connues en elles-mêmes, permet d'obtenir une réduction notable des capacités parasites et notamment de la capacité parasite latérale des interconnexions et de la résistance des contacts.

Bien entendu, diverses variantes et modifications apparaîtront à l'homme de métier qui pourra notamment choisir diverses variantes connues de réalisation des divers procédés de dépôt décrits.

## Revendications

1. Structure d'interconnexion dans laquelle :
la surface supérieure d'un premier niveau d'interconnexion (1) est une couche de tungstène (13, 14),
des portions (11, 12) du premier niveau d'interconnexion sont isolées les unes des autres par un isolant de type SOG (41),
des portions (21, 22) d'un deuxième niveau d'interconnexion (2) sont reliées à des portions (11, 12) du premier niveau d'interconnexion par des plots conducteurs (33, 34) formés dans des ouvertures d'une couche isolante dont au moins la partie inférieure est de type SOG,
les parois et le fond desdites ouvertures sont recouverts d'une couche mince de titane (31), et
les ouvertures sont remplies d'un matériau conducteur choisi dans le groupe comprenant Al, Cu et des alliages d'aluminium tels que des alliages de silicium, de cuivre, de titane...

2. Structure d'interconnexion selon la revendication 1, caractérisée en ce qu'elle comprend une couche mince de TiN sous la couche mince de titane.

3. Structure selon la revendication 1, caractérisée en ce que l'épaisseur de la couche de titane est inférieure à 30 nm et de préférence inférieure à 10 nm.

4. Structure selon les revendications 2 et 3, caractérisée en ce que l'épaisseur de la couche de TiN est de l'ordre d'une dizaine de nanomètres.

5. Procédé de formation de deux niveaux d'une structure d'interconnexion, caractérisé en ce qu'il comprend les étapes suivantes :
former un premier niveau d'interconnexion en un matériau choisi dans le groupe comprenant Al, Cu et des alliages d'aluminium tels que des alliages de silicium, de cuivre, de titane...
graver ce premier niveau d'interconnexion selon un motif choisi,
recouvrir la structure d'une couche isolante dont la partie inférieure, s'étendant entre les portions du premier niveau d'interconnexion et sur la surface supérieure du premier niveau d'interconnexion, est en un matériau de type SOG,
graver des ouvertures dans la couche isolante en regard de portions choisies du premier niveau d'interconnexion,
déposer une couche mince de titane,
former un deuxième niveau d'interconnexion et remplir lesdites ouvertures par dépôt à une température supérieure à 500°C d'un matériau choisi dans le groupe comprenant Al, Cu et des alliages d'aluminium.

6. Procédé selon la revendication 5, caractérisé en ce qu'il comprend en outre l'étape consistant à déposer sur le deuxième niveau d'interconnexion une couche mince de titane et une couche mince de tungstène et à graver ce deuxième niveau d'interconnexion selon des motifs choisis.

7. Procédé selon la revendication 5, caractérisé en ce qu'une couche mince de TiN est déposée avant la couche mince de titane.

8. Procédé selon la revendication 5, caractérisé en ce que l'épaisseur de la couche de titane est inférieure à 30 nm et de préférence inférieure à 10 nm.

9. Procédé selon les revendications 7 et 8, caractérisé en ce que l'épaisseur de la couche de TiN est de l'ordre d'une dizaine de nanomètres.
